# EUROPÄISCHE PATENTANMELDUNG

(11) **EP 1 973 130 A2**
(43) Veröffentlichungstag der Anmeldung: **24.09.2008**
(21) Anmeldenummer: 08004677.4
(22) Anmeldetag: 13.03.2008
(51) Int. Cl.: H01H 9/16

(54) **Schalter für Verbraucher in einem Gebäudestromnetz**

(30) Priorität: 17.03.2007 DE 202007004164 U
(71) Anmelder: Beck, Wilfried, 65191 Wiesbaden (DE)
(72) Erfinder: Beck, Wilfried, 65191 Wiesbaden (DE)
(74) Vertreter: Aue, Hans-Peter

(57) **Zusammenfassung**

Die Erfindung betrifft einen Schalter (1) mit einer Steuerelektronik (7) zum Visualisieren von Zustandsänderungen von mit jeweils einem individuellen Empfangselement (4) versehenen Verbrauchern (3) in einem Gebäudestromnetz (2). Der Schalter (1) umfasst ein Trägerelement (5) sowie zumindest ein zu bedienendes Betätigungselement (6), welches beweglich auf dem Trägerelement (5) angebracht ist. Das Betätigungselement (6) ist relativ zum Trägerelement (5) in mehr als eine Richtung bewegbar und jede Betätigung des Betätigungselementes (6) bewirkt mindestens einen Schaltvorgang. Weiterhin weist der Schalter (1) mindestens eine Anzeigeeinrichtung (9,11) auf, wobei jede Anzeigeeinrichtung (9,11) im Wesentlichen dort angebracht ist, wo das Betätigungselement (6) einen Schaltweg zurücklegt. Jede der Anzeigeeinrichtungen (9,11) weist eine andere Farbe auf.

## Beschreibung

Die Erfindung bezieht sich auf einen Schalter mit einer Steuerelektronik zum Visualisieren von Zustandsänderungen von mit jeweils einem individuellen Empfangselement versehenen Verbrauchern in einem Gebäudestromnetz.

Es ist allgemein bekannt, dass insbesondere im Bereich der Haustechnik eine Vielzahl von Verbrauchern, wie mehrere Lampen, Jalousien, Musikanlagen, Radios, Fernseh- und Videogeräte, Klimageräte, Alarmanlagen usw. in einem Raum oder in mehreren Bereichen nur über eine entsprechende Anzahl von Schaltern, gegebenenfalls Fernbedienungen, Displays usw. gesteuert werden, in dem die Schalter ihre Steuerbefehle an das zugeordnete Gerät senden. Hierbei sei beispielhaft nur auf die klassische Schaltung einer Lampe "Ein/Aus" mittels eines Wechselstrom-Wandschalters hingewiesen. Dem gemäß sind eine Vielzahl von Schaltern notwendig, deren Zahl umso größer ist, je größer die Anzahl der Räume und der Verbraucher ist. Hierbei soll unter dem Begriff "Schalter" jede Art von Schaltelement verstanden werden, das einen Schaltvorgang und eine Zustandsänderung des jeweiligen Verbrauchers bewirkt. Unter dem Begriff "Verbraucher" sind alle elektrisch steuerbaren Geräte zu verstehen.

In der Regel dient ein einzelner Schalter zum Schalten eines Verbrauchers. Dabei kann ein solcher Schalter aber auch mehrere Schaltvorgänge ausführen, z.B. "Ein/Aus" und "Dimmen". Bekannt sind auch Drehschalter, die Schaltvorgänge in mehreren Schaltstufen ausführen.

Zur Steuerung von mehreren Verbrauchern in einem Raum oder Bereich sind demnach Schalter mit einer höheren Anzahl von Sensoren und Tastern mit komplizierterem Aufbau und Untergliederung notwendig. Je vielzähliger und komplexer jedoch die Schalter sind, umso größer sind die Anforderungen bei der Bedienung an den Nutzer. Weiterhin sind solche Steuerungen auch über Sensor-Displaykombinationen bzw. Taster-Displaykombinationen möglich. Dabei stellt die Nutzung jedoch noch höhere Ansprüche an den Benutzer, da die Bedienung der gewünschten Schaltzustände und Funktionen nur über das Lesen der Displayinformationen in Kombination mit der Ausführung der Schalter möglich ist.

Umfangreiche Schaltermengen gegebenenfalls auch in Kombination mit Displays führen bei nicht wenigen Nutzern zu Verwirrung und Komplikationen beziehungsweise sogar zu Bedienungsängsten und Bedienungsablehnungen.

Es ist Aufgabe der Erfindung, einen Schalter der eingangs genannten Art zu schaffen, der eine sichere, komfortable und schnelle Steuerung mehrerer Verbraucher bzw. Gruppen von Verbrauchern ermöglicht, wobei die Steuerung leicht erlernbar und merkbar sein soll.

Erfindungsgemäß wird die Aufgabe gelöst durch
- ein Trägerelement,
- zumindest ein zu bedienendes Betätigungselement, welches beweglich auf dem Trägerelement angebracht ist,
   - wobei das Betätigungselement relativ zum Trägerelement in mehr als eine Richtung bewegbar ist, und
   - jede Betätigung des Betätigungselementes mindestens einen Schaltvorgang bewirkt,
- mindestens eine Anzeigeeinrichtung
   - wobei jede Anzeigeeinrichtung im Wesentlichen dort angebracht ist, wo das Betätigungselement einen Schaltweg zurücklegt,
   - jede der Anzeigeeinrichtungen eine andere Farbe aufweist.

Das Trägerelement kann nach Art eines Rahmens eines üblichen Wandschalters ausgebildet sein und nimmt das einzige Betätigungselement beweglich auf. Dieses Betätigungselement, das die eigentliche Schalterplatte des Schalters darstellt, kann an den Ecken und Kanten und im Zentrum durch Druckbewegung betätigt werden, d.h. räumlich gesehen in alle möglichen Richtungen und nicht nur in X-, Y- und Z-Richtung, so dass der Schalter als Multidimensionsschalter wirkt und bei jeder Betätigung einen entsprechenden Schaltvorgang an einem entsprechenden Verbraucher oder einer Verbrauchergruppe auslöst.

Das Betätigungselement kann ein einziges Betätigungselement mit mehreren Betätigungsflächen sein oder aber auch aus einer Mehrzahl von Betätigungselementen bestehen.

Da die Kanten, die Ecken und das Zentrum des Betätigungselementes des Schalters als Betätigungsbereiche genutzt werden, befinden sich die Anzeigeeinrichtungen zweckmäßigerweise in diesen Bereichen, bevorzugt jedoch in den Ecken des Betätigungselementes, da dies zur besseren Übersichtlichkeit beiträgt.

Der Schalter überträgt seine Schaltsignale vorzugsweise über das Gebäudestromnetz an eine Verbraucher oder eine Gruppe von Verbrauchern, die mit einem individuellen Empfangselement ausgerüstet sind. Dieses Empfangselement kann eine elektronische Einrichtung, beispielsweise Transponder oder ein Mikrochip sein, in dem eine codierte Kennung gespeichert ist, so dass nur der gewünschte Verbraucher auf den Schaltvorgang und die entsprechenden Steuerbefehle des Schalters reagiert.

Erfindungsgemäß können nun über einen einzigen Schalter ein einzelner Verbraucher, ein komplexer Verbraucher und eine oder mehrere Gruppen von gleichgearteten oder mehrgearteten Verbrauchern bedient und gesteuert werden. Das bedeutet, dass eine Lampe oder mehrere Lampen, auch Gruppen von Lampen sowie Jalousien, Gruppen von Jalousien, Alarmanlagen, Klimaanlagen, elektrische Hausgeräte, Audio- und Videogeräte, Fernsehgeräte usw. mit einem einzigen Schalter über das Gebäudestromnetz geschaltet werden können. Natürlich kann in jedem Raum eines Bereiches ein solcher Schalter an der Wand des Raumes vorgesehen und mit dem Gebäudestromnetz verbunden werden. Dadurch lassen sich beliebige Verbraucher auch in anderen Räumen schalten und steuern. Die Bedienung erfolgt allein durch lokale Bewegung bzw. Berührung der Oberfläche des Schalters.

Ein weiterer Vorteil des erfindungsgemäßen Schalters besteht darin, dass dieser sich optisch nicht von den an sich üblichen und bekannten Schaltern unterscheiden muss. So müssen die vielfältigen Bedienmöglichkeiten des Schalters für den Nutzer auf den ersten Blick nicht erkennbar sein.

Die vielfältigen Schaltmöglichkeiten des Schalters für die Verbraucher ergeben sich durch die oberen und/oder unteren Bereiche, die rechten und/oder linken Bereiche und/oder den mittleren Bereich des Betätigungselementes, die allesamt zur Weitergabe von Steuerungsbefehlen verwendet werden.

Bei normalen, an sich bekannten Schaltern wird im Schalter durch eine mechanische Betätigung im Schalter selbst ein Stromkreis geschlossen. Bei dem erfindungsgemäßen Schalter ist das nicht der Fall. Vielmehr wird durch die mechanische Betätigung des Schalters eine Information aus einem Speicher, der sich in der Steuerelektronik im Schalter befindet, identifiziert, ausgewählt und diese Information wird im gesamten Gebäudestromnetz bereitgestellt und dann lokal vom Empfangselement im Verbraucher interpretiert.

Weitere Merkmale der Erfindung ergeben sich aus den Unteransprüchen.

Sonach ist bevorzugt jeder Anzeigeeinrichtung bzw. Farbe ein bestimmter Verbraucher bzw. eine bestimmte Gruppe von Verbrauchern zugeordnet. Beispielsweise stehen die Farben für folgende Kategorien von Verbrauchern:

**(Tabelle 1)**

| **Farbe** | **Kategorie** | **Verbraucher/Verbrauchergruppe** |
|---|---|---|
| Gelb | Beleuchtung | Lampen |
| Grau | Schatten | Jalousien, Markiesen |
| Blau | Klima | Klimaanlage, Luftbefeuchter |
| Zyan | Audio | Stereoanlage |
| Magenta | Video | Fernsehgeräte |
| Rot | Sicherheit | Alarmanlage |
| Grün | Zugang | Türöffner |
| usw. | | |

Gemäß einer weiteren Ausgestaltung des erfindungsgemäßen Schalters ist jede Anzeigeeinrichtung vorzugsweise in einer Ecke oder Kante des Betätigungselementes angeordnet. Dabei ist eine Anzeigeeinrichtung in einer Ecke oder Kante beispielsweise für die Schaltung von Lampen eines oder mehrerer Räume, eine Anzeigeeinrichtung in einer anderen Ecke oder Kante für die Schaltung von elektronischen Unterhaltungsgeräten, wie Fernsehgeräte, Audiogeräte usw., eine weitere Anzeigeeinrichtung in einer anderen Ecke oder Kante für die Betätigung von Jalousien und wieder eine andere Anzeigeeinrichtung in einer Ecke oder Kante für die Betätigung einer Alarmanlage vorgesehen, wobei die Zuordnung der Verbrauchergruppen durch Programmierung der Steuerelektronik des Schalters verändert werden kann.

Weiterhin ist vorgesehen, dass mehr als eine Kante des Betätigungselementes mindestens einen Schaltvorgang für mindestens einen Verbraucher oder mindestens einer Gruppe von Verbrauchern bewirkt. Die oberen, unteren, rechten und linken Kanten des Betätigungselementes ermöglichen somit unterschiedliche Schaltvorgänge, die vom Nutzer intuitiv erkannt und benutzt werden. Die Kanten des Betätigungselementes können beispielhaft und bevorzugt folgende Bedienfunktionen umfassen:

**(Tabelle 2)**

| **Kante/Zentrum** | **Funktionen** |
|---|---|
| Oben | plus, heller, höher, mehr, lauter, wärmer |
| Unten | minus, dunkler, tiefer, weniger, leiser, kälter |
| Links | links, zurück, letztes |
| Rechts | rechts, weiter, nächstes |
| Zentrum | An/Aus, Start/Stopp, Play/Pause, Kommen/Gehen |

Dabei beziehen sich die Schaltfunktionen nicht nur auf einen zu steuernden Verbraucher, beispielsweise ein Fernsehgerät, der an- bzw. auszuschalten ist, sondern auch auf andere Funktionen, wie den nächsten Fernsehkanal wählen. Bei einer Lampe kann dies beispielsweise die Steuerung der Helligkeit oder das Hinzufügen weiterer Lampen sein, bei einem CD-Player die Wahl des nächsten oder vorhergehenden Musiktitels, bei einer Jalousie die Einstellhöhe usw..

Des Weiteren bewirkt mehr als eine Ecke des Betätigungselementes mindestens eine Schaltvorgangauswahl für mindestens einen Verbraucher oder mindestens einer Gruppe von Verbrauchern. Demgemäß sind die Verbraucherarten den Ecken des Betätigungselementes des Schalters zugeordnet, beispielsweise wie folgt:

**(Tabelle 3)**

| **Ecke** | **Verbrauchergruppe** |
|---|---|
| Oben links | Beleuchtung (Lampen) |
| Oben rechts | Audio/Video (Fernseher, CD-PLayer usw.) |
| Unten links | Schatten (Jalousien) |
| Unten rechts | Sicherheit (Alarmanlage) |

Nach einer Weiterbildung des erfindungsgemäßen Schalters bewirkt das Zentrum des Betätigungselementes mindestens einen Schaltvorgang für mindestens einen Verbraucher oder mindestens einer Gruppe von Verbrauchern. Dabei wird eine Verbrauchergruppe, z.B. Lampen, in einer Ecke des Betätigungselements vorgewählt und dann bei Betätigung des Zentrums des Betätigungselementes z.B. ein Einschaltvorgang für die entsprechende Verbrauchergruppe gewählt.

Dem entsprechend bewirken mehr als eine Ecke und/oder mehr als eine Kante und/oder das Zentrum des Betätigungselementes mehr als einen Schaltvorgang für einen Verbraucher oder einer Gruppe von Verbrauchern.

Darüber hinaus ist vorgesehen, dass das Betätigungselement relativ zum Trägerelement in mehr als eine Richtung, nämlich vorzugsweise in X-, Y- und Z-Richtung bewegbar oder um eine dieser Achsen drehbar ist.

Weiterhin zeigt das Zentrum des Betätigungselementes die jeweilige Farbe des aktuellen Schaltzustandes der jeweiligen Anzeigeeinrichtung an den Ecken des Betätigungselementes an. Wurde also beispielsweise die Verbrauchergruppe "Beleuchtung" gewählt, leuchtet das Zentrum des Betätigungselementes in gelber Farbe, bei der Wahl der Verbrauchergruppe "Schatten" leuchtet das Zentrum in grauer Farbe usw..

Gemäß einer Weiterbildung der Erfindung setzen sich die Farben der Anzeigeeinrichtungen aus den Rot-Grün-Blau-Farben (RGB-Farben) zusammen, um damit sieben Farben unterscheiden zu können, nämlich zusätzlich noch die Farben Gelb, Zyan, Magenta und Weiß. Ferner erfolgt die Wiedergabe der Rot-Grün-Blau-Farben durch Rot-Grün-Blau-LEDs.

Ein weiterer Vorteil des Schalters ergibt sich dadurch, dass zusätzlich zum Betätigungselement oder Trägerelement eine Fernbedienung vorgesehen ist, welche die Schaltvorgänge des Betätigungselementes für mindestens einen Verbraucher oder mindestens einer Gruppe von Verbrauchern bewirkt. Alle zuvor beschriebenen Funktionen können somit auch durch eine Fernbedienung realisiert werden. Der Nutzer kann daher die Funktionen des Schalters bequem beispielsweise aus einem vom Schalter entfernten Ort eines Raumes oder Bereiches nutzen und die Verbraucher schalten und steuern. Als Fernbedienung kann beispielsweise auch ein Mobiltelefon verwendet werden.

Hierbei kann die Fernbedienung mindestens eine der genannten Anzeigeeinrichtungen aufweisen, um deren Betätigung zu erleichtern und komfortabel zu gestalten.

An sich ist der erfindungsgemäße Schalter für Blinde nicht geeignet, da für sie die Farben nicht erkennbar sind. Daher kann ein wesentliches Hilfsmittel des Schalters sein, dass dieser anstelle der Farben oder zusätzlich zu den Farben unterschiedliche Audiosignale erzeugt, welche die jeweiligen Schaltzustände signalisieren. Die Audiosignale können sich somit in Klanghöhe und/oder Klanglänge und/oder Klangton unterscheiden. Damit wird eine Steuerung und Schaltung von Verbrauchern auch für Blinde erleichtert.

Besonders komfortabel ist der Schalter, wenn dieser bei jedem Schaltvorgang sowohl mindestens ein Farbsignal als auch eine korrespondierende Zeichenfolge ausgibt, welche die durch das Farbsignal repräsentierte Funktion bezeichnet. Diese Zeichenfolge kann dabei die durch das Farbsignal repräsentierte Funktion bezeichnen, indem diese durch ein kleines Display am Schalter dargestellt wird.

Weiterhin kann der Schalter einen Berührungs-, Näherungs- oder Bewegungssensor aufweisen, so dass der Schalter durch Annäherung des Nutzers in Funktions- und Schaltbereitschaft setzbar ist.

Möglich wäre auch eine Ausbildung des Schalters mit einem runden Betätigungselement, das zum Wippen in mehreren Richtungen geeignet ist. Hierfür wären dann andere Bezugspunkte zu definieren, beispielsweise nach Art eines Uhrenzifferblattes. So können beispielsweise die "Kanten" als 3, 6, 9 und 12 Uhr bezeichnet und entsprechend am Betätigungselement ausgebildet sein. In analoger Weise könnten die "Ecken" definiert werden.

Weiterhin kann der erfindungsgemäße Schalter beispielsweise in einem Gebäudestromnetz eingebaut sein. Unter einem Gebäudestromnetz wird in diesem Fall der Teil eines Stromnetzes verstanden, der sich nach dem Zähler des Stromversorgungsunternehmens befindet, und an dem die Verbraucher angeschlossen sind, wobei es unerheblich ist, welchen Charakter ein solches Gebäude hat. Umfasst sind also sowohl feste Gebäude, als auch auf- und abbaubare Gebäude oder Zelte, die mit einem eigenen Stromnetz versorgt werden. Hierunter fallen auch Stromnetze, welche für Veranstaltungen in möglicherweise auch offen gestalteten Gebäuden, wie z.B. Bühnen, dauerhaft bestehen oder situativ auf- und wieder abgebaut werden. Wesentlich ist alleine, dass sich ein erfindungsgemäßer Schalter in diesem Teil des Gebäudestromnetzes befindet und bereit steht, erfindungsgemäße Wirkung zu entfalten.

Darüber hinaus kann der erfindungsgemäße Schalter in eine Wohneinheit eingebaut sein, auch ohne an ein zuvor definiertes Gebäudestromnetz angeschlossen zu sein. Dies ist beispielsweise der Fall, wenn die erfindungsgemäßen Schaltern in einem Netz verbaut sind, in welches nicht, wie zuvor definiert, ein Zähler eines Stromversorgungsunternehmens eingebaut ist. Dies ist zunehmend in Gebäuden der Fall, die ihren Strom, beispielsweise durch Blockkraftwerke, unabhängig von Stromversorgern selbst produzieren.

Die Funktionen des Schalters können neben einem Wechselstromnetz natürlich auch in einem Gleichstromnetz, einem Bussystem und weiterhin zur Übermittlung von Funksignalen verwendet werden.

Es versteht sich, dass die vorstehend genannten und nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

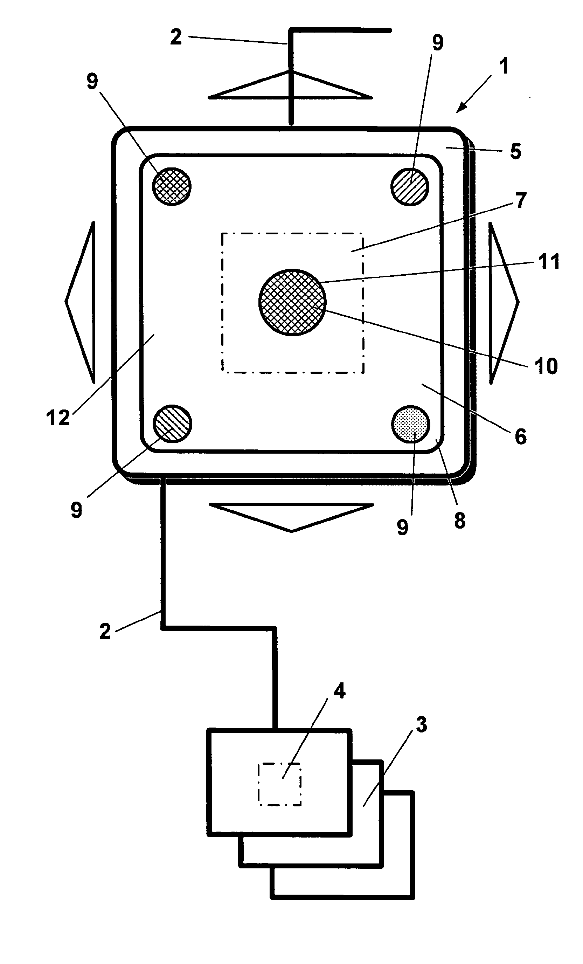

Der der Erfindung zugrunde liegende Gedanke wird in der nachfolgenden Beschreibung anhand eines Ausführungsbeispieles, das in der Zeichnung dargestellt ist, näher beschrieben. Die Zeichnungsfigur zeigt einen erfindungsgemäßen Schalter in Verbindung mit einer Verbrauchergruppe.

Der Schalter 1 ist an einer Wand eines Raumes angebracht und direkt oder per Infrarot/Bussystem oder per Funk an ein Gebäudestromnetz 2 angeschlossen. Darüber hinaus ist der Schalter 1 über das Gebäudestromnetz 2 mit einer oder mehreren Gruppen von Verbrauchern 3 verbunden, die in der Zeichnung symbolhaft dargestellt sind. Jeder Verbraucher 3 enthält ein codiertes Empfangselement 4, z.B. einen Mikrochip, zum Empfang der Schaltsignale des Schalters 1.

Der Schalter 1 weist ein Trägerelement 5 auf, das den Rahmen des Schalters 1 bildet. Am Trägerelement 5 ist vorzugsweise ein einziges zu bedienendes Betätigungselement 6 angebracht, das mit einer dahinter eingebauten Steuerelektronik 7 in Kontaktverbindung steht. In den Ecken 8 des Betätigungselementes 6 ist jeweils eine Anzeigeeinrichtung 9 ausgebildet, die jeweils eine bestimmte Farbe wiedergibt.

Die obere linke Anzeigeeinrichtung 9 in der Ecke 8 leuchtet z.B. Gelb (Kreuzschraffur) für die Verbrauchergruppe "Lampen" zum Schalten von Lampen, die obere rechte Anzeigeeinrichtung 9 in der Ecke 8 leuchtet Grün (Rechtsschraffur) für die Verbrauchergruppe "Audio/Video" zum Schalten von elektronischen Unterhaltungsgeräten, die untere linke Anzeigeeinrichtung 9 in der Ecke 8 leuchtet Grau (Linksschraffur) für die Verbrauchergruppe "Schatten" zum Schalten von Jalousien und die untere rechte Anzeigeeinrichtung 9 in der Ecke 8 leuchtet Rot (Punktiert) für die Verbrauchergruppe "Sicherheit" zum Schalten für die Alarmanlage.

Im Zentrum 10 des Betätigungselementes 6 ist eine Anzeigeeinrichtung 11 ausgebildet, die in der Farbe der momentan oder zuletzt aktiven Verbraucher 3 leuchtet, die zuvor aus einer der Ecken 8 des Betätigungselementes 6 (Tabelle 3) ausgewählt wurden.

Nur symbolisch sind in der Zeichnung die vier Pfeile nahe den Kanten 12 des Schalters 1 dargestellt, welche die schaltbaren Funktionen der jeweils ausgewählten Verbraucher 3 zeigen. Durch Betätigen beispielsweise der rechten Kante des Betätigungselementes 6 des Schalters 1 werden die Schaltfunktionen "rechts, weiter, nächstes" ausgelöst. Bei Betätigung der anderen Kanten 12 des Betätigungselementes 6 werden die in Tabelle 2 genannten Schaltfunktionen ausgeführt.

### Liste der Bezugszeichen

- 1: Schalter
- 2: Gebäudestromnetz
- 3: Verbraucher
- 4: Empfangselement
- 5: Trägerelement
- 6: Betätigungselement
- 7: Steuerelektronik
- 8: Ecke
- 9: Anzeigeeinrichtung
- 10: Zentrum
- 11: Anzeigeeinrichtung
- 12: Kante

## Patentansprüche

1. Schalter (1) mit einer Steuerelektronik (7) zum Visualisieren von Zustandsänderungen von mit jeweils einem individuellen Empfangselement (4) versehenen Verbrauchern (3) in einem Gebäudestromnetz (2), **gekennzeichnet durch**
- ein Trägerelement (5),
- zumindest ein zu bedienendes Betätigungselement (6), welches beweglich auf dem Trägerelement (5) angebracht ist,
- wobei das Betätigungselement (6) relativ zum Trägerelement (5) in mehr als eine Richtung bewegbar ist, und
- jede Betätigung des Betätigungselementes (6) mindestens einen Schaltvorgang bewirkt,
- mindestens eine Anzeigeeinrichtung (9,11)
- wobei jede Anzeigeeinrichtung (9,11) im Wesentlichen dort angebracht ist, wo das Betätigungselement (6) einen Schaltweg zurücklegt,
- jede der Anzeigeeinrichtungen (9,11) eine andere Farbe aufweist.

2. Schalter nach Anspruch 1, **dadurch gekennzeichnet, dass** jeder Anzeigeeinrichtung (9,11) bzw. Farbe ein bestimmter Verbraucher (3) bzw. eine bestimmte Gruppe von Verbrauchern (3) zugeordnet ist.

3. Schalter nach Anspruch 1 oder 2, **dadurch gekennzeichnet, dass** jede Anzeigeeinrichtung (9,11) vorzugsweise in einer Ecke (9) oder Kante (12) des Betätigungselementes (6) angeordnet ist.

4. Schalter nach einem der Ansprüche 1 bis 3, **dadurch gekennzeichnet, dass** mehr als eine Kante (12) des Betätigungselementes (6) mindestens einen Schaltvorgang für mindestens einen Verbraucher (3) oder mindestens einer Gruppe von Verbrauchern (3) bewirkt.

5. Schalter nach einem der Ansprüche 1 bis 4, **dadurch gekennzeichnet, dass** mehr als eine Ecke (8) des Betätigungselementes (6) mindestens eine Schaltvorgangauswahl für mindestens einen Verbraucher (3) oder mindestens einer Gruppe von Verbrauchern (3) bewirkt.

6. Schalter nach einem der Ansprüche 1 bis 5, **dadurch gekennzeichnet, dass** das Zentrum (10) des Betätigungselementes (6) mindestens einen Schaltvorgang für mindestens einen Verbraucher (3) oder mindestens einer Gruppe von Verbrauchern (3) bewirkt.

7. Schalter nach einem der Ansprüche 1 bis 6, **dadurch gekennzeichnet, dass** mehr als eine Ecke (8) und/oder mehr als eine Kante (12) und/oder das Zentrum (10) des Betätigungselementes (6) mehr als einen Schaltvorgang für mindestens einen Verbraucher (3) oder mindestens einer Gruppe von Verbrauchern (3) bewirken.

8. Schalter nach einem der Ansprüche 1 bis 7, **dadurch gekennzeichnet, dass** das Betätigungselement (6) relativ zum Trägerelement (5) in mehr als eine Richtung, nämlich vorzugsweise in X-, Y- und Z-Richtung, bewegbar oder um eine dieser Achsen drehbar ist.

9. Schalter nach einem der Ansprüche 1 bis 8, **dadurch gekennzeichnet, dass** das Zentrum (10) des Betätigungselementes (6) die jeweilige Farbe des aktuellen Schaltzustandes der jeweiligen Anzeigeeinrichtung (9) an Ecken (8) des Betätigungselementes (6) anzeigt.

10. Schalter nach einem der Ansprüche 1 bis 9, **dadurch gekennzeichnet, dass** sich die Farben der Anzeigeeinrichtungen (9,11) aus den Rot-Grün-Blau-Farben zusammensetzen, um damit sieben Farben unterscheiden zu können.

11. Schalter nach einem der Ansprüche 1 bis 10, **dadurch gekennzeichnet, dass** die Wiedergabe der Rot-Grün-Blau-Farben durch Rot-Grün-Blau-LEDs erfolgt.

12. Schalter nach einem der Ansprüche 1 bis 11, **dadurch gekennzeichnet, dass** zusätzlich zum Betätigungselement (6) oder Trägerelement (5) eine Fernbedienung vorgesehen ist, welche die Schaltvorgänge des Betätigungselementes (6) für mindestens einen Verbraucher (3) oder mindestens einer Gruppe von Verbrauchern (3) bewirkt.

13. Schalter nach einem der Ansprüche 1 bis 12, **dadurch gekennzeichnet, dass** die Fernbedienung mindestens eine der genannten Anzeigeeinrichtungen (9,11) aufweist.

14. Schalter nach einem der Ansprüche 1 bis 13, **dadurch gekennzeichnet, dass** dieser anstelle der Farben oder zusätzlich zu den Farben unterschiedliche Audiosignale erzeugt, welche die jeweiligen Schaltzustände signalisieren.

15. Schalter nach einem der Ansprüche 1 bis 14, **dadurch gekennzeichnet, dass** dieser bei jedem Schaltvorgang sowohl mindestens ein Farbsignal als auch eine korrespondierende Zeichenfolge ausgibt, welche die durch das Farbsignal repräsentierte Funktion bezeichnet.

16. Schalter nach einem der Ansprüche 1 bis 15, **dadurch gekennzeichnet, dass** dieser einen Berührungs-, Näherungs- oder Bewegungssensor aufweist, so dass der Schalter (1) durch Annäherung des Nutzers in Funktions- und Schaltbereitschaft setzbar ist.

17. Gebäudestromnetz nach einem der vorhergehenden Ansprüche, umfassend mindestens einen Schalter (1) mit einer Steuerelektronik (7) zum Visualisieren von Zustandsänderungen von mit jeweils einem individuellen Empfangselement (4) versehenen Verbrauchern (3) in dem Gebäudestromnetz (2).

18. Wohneinheit nach Anspruch 17, umfassend mindestens ein Gebäudestromnetz mit mindestens einem Schalter (1) mit einer Steuerelektronik (7) zum Visualisieren von Zustandsänderungen von mit jeweils einem individuellen Empfangselement (4) versehenen Verbrauchern (3) in dem Gebäudestromnetz (2).
